(19) Europäisches Patentamt
European Patent Office
Office européen des brevets

(11) EP 0 562 751 B1

(12) EUROPEAN PATENT SPECIFICATION

(45) Date of publication and mention of the grant of the patent:
**01.07.1998  Bulletin 1998/27**

(51) Int Cl.$^6$: **H03K 19/08**

(21) Application number: **93301982.0**

(22) Date of filing: **16.03.1993**

(54) **Logic device**

Logische Schaltung

Circuit logique

(84) Designated Contracting States:
**DE FR GB NL**

(30) Priority: **25.03.1992  GB 9206812**

(43) Date of publication of application:
**29.09.1993  Bulletin 1993/39**

(73) Proprietor: **HITACHI EUROPE LIMITED**
**Maidenhead, Berkshire, SL6 8YA (GB)**

(72) Inventors:
• **Nakazato, Kazuo**
**Cambridge, CB1 4PA (GB)**
• **White, Julian D.**
**Histon, Cambridge, CB4 4HY (GB)**

(74) Representative: **Read, Matthew Charles et al**
**Venner Shipley & Co.**
**20 Little Britain**
**London EC1A 7DH (GB)**

(56) References cited:
• **JOURNAL OF APPLIED PHYSICS vol. 72, no. 9 , 1 November 1992 , NEW YORK US pages 4399 - 4413 J.R.TUCKER 'complementary digital logic based on the "coulomb blockade"'**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

This invention relates to improved logic devices.

Conventional semiconductor logic devices utilise transistors in which one bit of information is carried by typically $10^5$ electrons. In principle information can be transmitted by only one electron, binary unity/zero being coded by the presence or absence of a single-electron in a certain metallic or semiconductor region. If a logic device is realised in which one electron represents one bit of information, power dissipation of such a device will be reduced by $10^{-5}$ compared to present day semiconductor devices.

Since Averin and Likharev pointed out the possibility of macroscopic charge quantization [D. V. Averin and K. K. Likharev, "Coulomb blockade of the single-electron tunelling, and coherent oscillation in a small tunnel junctions", J. Low Temp. Phys. 62, p345 (1986)], many research efforts have revealed that the motion of a single electron can be controlled. [L. J. Geerligs et al, "Frequency-Locked Turnstile Device for Single Electronic", Phys. Rev. Lett. 64, p2691, (1990), P. Lagarge et al, "Direct observations of macroscopic charge quantization", Z. Phys. B-Condensed Matter 85, p 327, (1991)] Single-electron transistor [K. K. Likharev, "Single-electron transistors: electrostatic analogues of the DC SQUIDS", IEEE transactions on magnetism, MAG-23, p1142 (1987)] and several kinds of single-electron logic circuits [K.K. Likharev and V. K. Semenov, "Possible Logic Circuits based on the correlated single-electron tunnelling in ultrasmall junctions", Ext. Abstr. of ISEC '87, Tokyo, p182, 1987] have been proposed, but these devices cannot operate at high speed because the single electrons are transmitted randomly in time, so it takes a long time to obtain reliable transmission of information.

In order to achieve high-speed operation, single-electrons need to be transmitted in a well-controlled in time sequence.

According to the present invention there is provided a logic device comprising: a charge storage node; barrier means; clock means for selectively altering the probability of charge carriers passing through the barrier means to the node during a clocking period, the device being so arranged that the amount of charge at the node is limited by Coulomb blockade whereby to define first and second logical levels; and output logic means for providing an output logic signal with different logical states in response to said logical levels of the node.

Thus, in accordance with the invention, a single carrier flow can be achieved utilising Coulomb blockade, and the carrier flow occurs during a predetermined clocking period in order to provide reliable transmission of information.

Reference is directed to "Encylopedic Dictionary of Electronics and Nuclear Engineering" by R. Sarbacher Sc. D-Pitman, in which, for the definition for "clock pulse", it is stated that clock pulses may be periodic or aperiodic.

In order that the invention may be more fully understood embodiments thereof will now be described by way of example, with reference to the accompanying drawings in which:

Figure 1 is a schematic circuit diagram of a logic device in accordance with the invention which includes a sequential chain of logic nodes;

Figure 2 is a circuit diagram, similar to Figure 1, for explaining operation of the device;

Figure 3 shows clocking waveforms applied to the clocking lines of Figure 2;

Figure 4 illustrates schematically two nodes of the device shown in Figure 1 for use in explaining permissible electron states thereof;

Figure 5 is a schematic representation of permissible electron states of the device shown in Figure 4;

Figure 6 illustrates schematically the effect of the clocking waveform on adjacent nodes in the device of Figure 1;

Figure 7 illustrates a node symbol used in the drawings herein;

Figure 8 illustrates the circuit of Figure 1 using the node symbol of Figure 7;

Figure 9 is a schematic circuit diagram of a logic device in accordance with the invention in the form of a two dimensional array;

Figure 10 illustrates operation of certain nodes within the array of Figure 9;

Figure 11 illustrates potentials occuring in the configuration of Figure 10;

Figure 12 illustrates an array that forms an AND and a NOT circuit;

Figure 13 illustrates an AND and an EXOR (Exclusive OR) circuit;

Figure 14 illustrates a bistable switch;

Figure 15 is a schematic circuit diagram of a logic device according to the invention including voltage source and an output unit;

Figure 16 illustrates a modification of the logic device utilising four clock waveforms;

Figure 17 is a plan view of an integrated circuit structure of a logic device according to the invention;

Figure 18 is a schematic partial cross sectional view of the device shown in Figure 17;

Figure 19 is illustrative of symbology for multi-tunnel junctions (MTJs);

Figure 20 illustrates a modification to Figure 12, using MTJs;

Figures 21 and 22 illustrate a modification to the clocking lines using a strip line arrangement;

Figure 23 is a schematic graph of the potential transmitted along the strip line;

Figure 24 is a schematic sectional view of a device according to the invention, with a strip line according to Figure 22; and

Figure 25 shows an alternative form of electrometer.

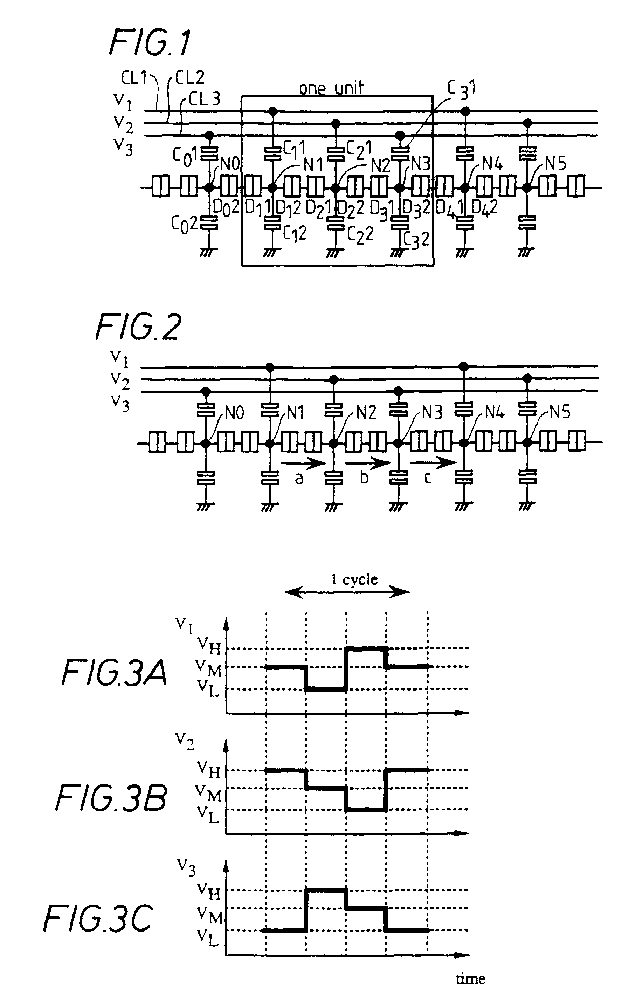

Referring to Figure 1, a first embodiment of the invention is shown schematically and consists of a device for sequential transfer of digital information between successive nodes arranged in a line. The digital information is represented by the presence or absence of a single electron at a particular node, e.g. the presence of electron e = 1; absence of an electron e = 0.

The nodes are referenced N0, N1, N2, N3, N4, N5 in Figure 1. Information is clocked between the nodes N0, - N5 by the application of cyclic clock signals of different phases V1, V2, V3, on clock lines CL1, CL2, CL3. It will be seen that the nodes N1 - N3 are connected in series with nodes N0 and N4, N5. In this embodiment, the nodes N1 - N3 can be considered to define a single logic unit within the node sequence.

Each node is connected to a respective clock line CL by a capacitor C1 and is connected to earth through capacitor C2. Thus, the node N1 is connected to clock line CL1 by capacitor C1 1, and to earth through capacitor C1 2.

The nodes are interconnected by pairs of tunnel diodes connected in series. Thus, node N1 is connected in series with node N2 through tunnel diodes D1 2 and D2 1. Similarly, node N2 is connected to node N3 through tunnel diodes D2 2 and D3 1.

By applying appropriate cyclic clocking signals V1, V2, V3 to the clock lines CL1, CL2, CL3, the electron state of node N1 can be transferred to node N2, and, the state of node N2 can be transferred to node N3, with the state of node N3 being transferred to node N4. The level of charge established in each of the nodes is limited by Coulomb blockade, as will be explained in more detail hereinafter, so that for each node, only two electron states can exist i.e. the presence of an electron (logical state 1) or the absence of an electron (logical state 0).

In the unitary logic cell (nodes N1 - N3) node N1 constitutes an information node and nodes N2, N3 constitute transfer nodes which act as buffer storage. The information node N1 can, at the start of one complete clocking cycle, have an electron state equal 1 or 0, whilst the transfer nodes N2, N3 are empty. As a result of applying the clocking voltages V1, V2, V3, the information of node N1 is firstly transferred into node N2 and then to N3. At the start of the next clocking cycle, the state of N3 is transferred to node N4 which constitutes the information node of the next logic unit in the sequence.

As previously mentioned, the electron flow between the nodes is limited to one electron by a phenomena known as Coulomb blockade. As discussed by Geerligs et al *supra* it has been found that a simple tunnel junction which is characterised by a very small capacitance can exhibit Coulomb blockade. For a capacitor of capacitance C, the energy that needs to be imparted to a single electron $\Delta E_c$ to force the electron into the capacitor is the charging energy of a single electron which is given by

$$\Delta E_c = \frac{e^2}{2C} \tag{1}$$

where e is the charge on the electron. If the capacitor is very small, this quantity can become significant in comparison with the energy supplied by the external voltage source of magnitude V which is eV. If the condition $\Delta E_c > eV$ is satisfied, no current can pass through the device, and this is known as Coulomb blockade of single electron tunnelling.

Thus, referring to Figure 1, the clocking voltages V1 - V3 are selected so that bias conditions are established between adjacent nodes across the interconnecting tunnelling diodes to cause electron tunnelling from one node to the next, but such that only one electron can tunnel through the diodes between the nodes. Further electron tunnelling is inhibited by Coulomb blockade. In practice, as shown in Figure 1, two tunnel diodes are provided between each node. Thus, for example between the node N1 and N2, two tunnel diodes D1 2 and D2 1 are provided. It can be shown that once an electron has tunnelled through a first of the diodes an energy selection process occurs and as a result, the electron can tunnel on through the second diode.

Referring to Figure 2, this shows schematically the circuit of Figure 1, in which the states of nodes N1, N2, N3 are shown as a states a, b, c, respectively. In Figure 3a, b, c, the clocking waveforms V1, V2, V3 are shown schematically. Each of the clocking waveforms is switched cyclically in the manner shown between a middle, high and low voltage VH, VM, VL. The waveform is selected so as to apply appropriate bias voltages between adjacent nodes to cause electron transfer thereby transferring the states a, b, c in the manner shown in Figure 2.

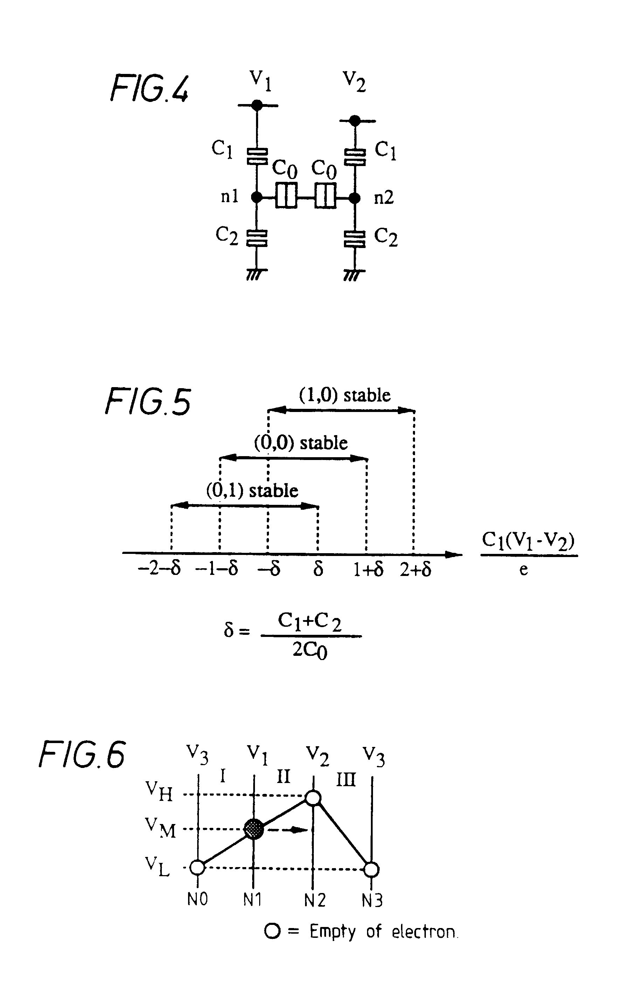

This will be explained in more detail with reference to Figures 4, 5 and 6.

Referring to Figure 4, this shows schematically the two nodes N1, N2. In this analysis, it is assumed that the capacitor C1 for each node is of the same value. Likewise, it is assumed that capacitor C2 for each node is of the same value. The capacitance associated with the tunnel diodes D1 2 and D2 1 are considered equal and of a value C0. The number of electrons on each of the nodes N1, N2 is designated n1, n2 respectively.

The electron state of the system shown in Figure 4 is denoted as (n1, n2). Thus, for example (1, 0) means that one electron occupies the left node N1 (n1 = 1) and an electron is absent from the node N2 (n2 = 0).

Figure 5 is a plot of the stable electron states associated with the system shown in Figure 4. The drawing shows a plot of C1(V1-V2)/e, which is indicative of the difference between the electron states of nodes N1 and N2. The range of stable states can be characterised in terms of a factor $\delta$ where:

$$\delta = \frac{C_1 + C_2}{2C_0} \qquad (2)$$

Referring now to Figure 6, this shows schematically the three different bias voltage levels VL, VM, VH that can be applied to each of the nodes N0, N1, N2, N3 by means of the clocking waveforms V1, V2, V3.

Considering the electron state of the node N1, it is desired to shift this electron state progressively to the right i.e. to node N2.

Thus, for nodes N1 and N2, there are three successive conditions that need to be satisfied, which can be expressed as follows:

requirement

I    (1,0) unstable                $\delta < \dfrac{C_1(V_M - V_L)}{e} < 1 + \delta$
      (0,0) stable

II    (1,0) unstable             $\delta < \dfrac{C_1(V_H - V_M)}{e} < 1 + \delta$
      (0,0) and (0,1) stable

III   (0,0) and (1,0) stable     $\delta < \dfrac{C_1(V_H - V_L)}{e} < 1 + \delta$
      (0,1) unstable

By substituting typical value capacitances in the inequalities given above, it is possible to compute appropriate values for VH, VL and VM that will achieve an appropriate sequential electron state transfer between the sequence of nodes.

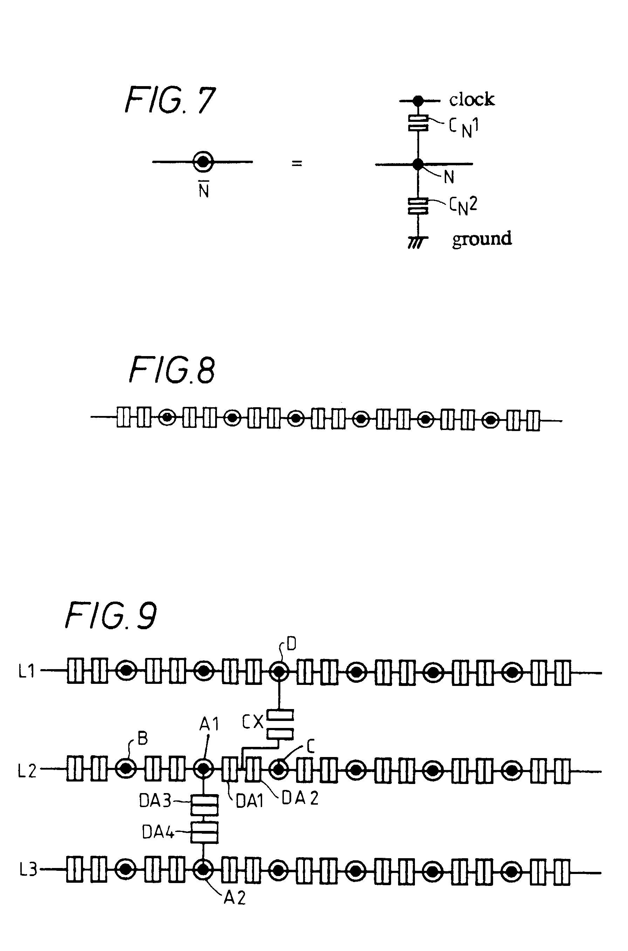

In Figure 7, a new symbol $\bar{N}$ is defined in order to represent the node N and its associated capacitors and clocking lines. Thus, using the new notation, the circuit of Figure 1 can be represented as shown in Figure 8. This provides an essentially one-dimensional array, which permits sequential information transfer. However, the circuitry can be expanded into two or multi-dimensional arrays to perform logic functions.

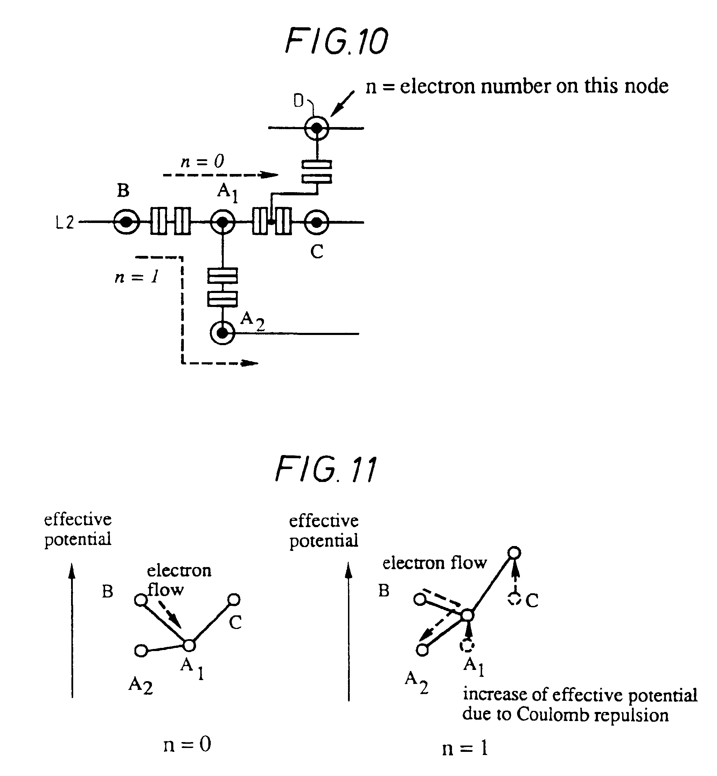

An example of a two-dimensional array is shown in Figure 9. Three parallel linear arrays of nodes L1, L2, L3 are provided. In this example, a capacitive coupling CX is provided between node D in line L1 and a connection between tunnel diodes DA1 and DA2. Node A1 in line L2 is coupled to node A2 in line L3 by a pair of tunnel diodes DA3 and DA4. The cross coupling between the lines is to perform logic functions since the electron occupancy of the nodes are cross coupled between the lines as will now be explained in more detail with reference to Figure 10. Considering the electron state of node D, n represents the electron number on the node. When n = 0, the state of node D does not influence the state of node A1 and as a result, logical information is transferred along line L2 from node B to node A1 and then to node C sequentially in the manner described with reference to Figure 1.

However, when an electron is present at node D on line L1 (n = 1) a potential is applied through capacitor CX and tunnel diode DA1 to the node A1, with the result that Coulomb blockade occurs. Accordingly, when the electron state of node B is clocked (as described with reference to Figure 1) in the direction of node A1, an unstable state occurs at node A1 so that the electron state of node B is transferred through tunnel diodes DA3 and DA4 to node A2. Thus, data from line L2 is switched to line L3 depending on the electron state of node D in line L1.

This is shown schematically in Figure 11, which illustrates the effective potential for the various nodes for the two different states of node D i.e. n = 0 and n = 1. The effective potential shown in Figure 11 is given by

$$\text{effective potential} = -\frac{C_1}{e} V_{clock} + \frac{Q_{ind}}{e}$$

$$V_{clock} = \text{clock voltage}$$

$$Q_{ind} = \text{induced charge by surrounding electrons}$$

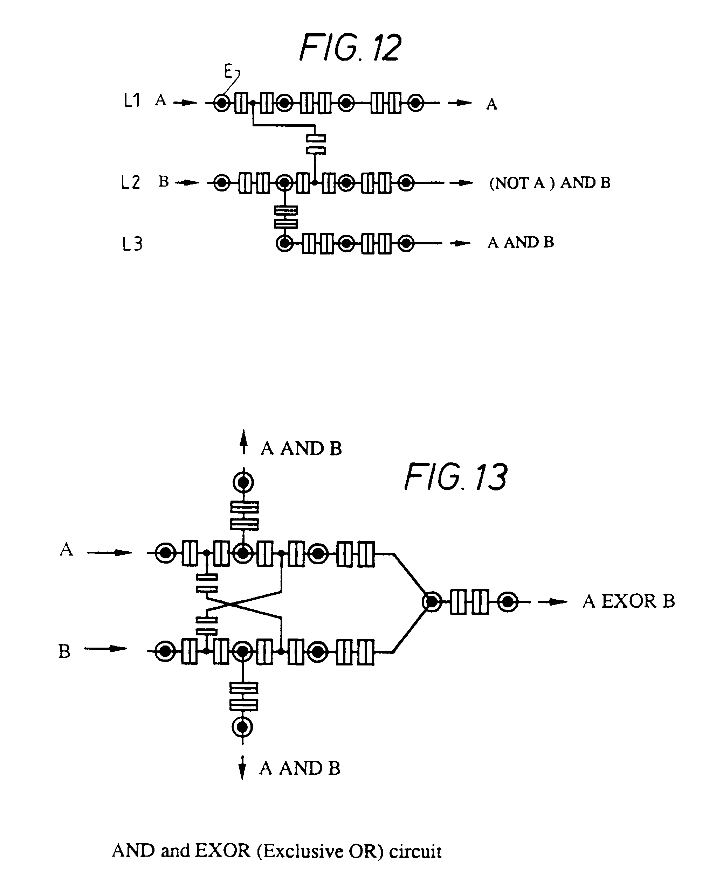

Much more complicated logical circuits can be produced. Referring to Figure 12, an AND and NOT circuit is shown which, in response to logical inputs A and B on lines L1, L2, produces output A on line L1, (NOT A) AND B on line L2, and A AND B on line L3. The three lines L1, L2, L3 are clocked in synchronism in the manner described with reference to Figure 1. The presence of an electron on node E of line L1 inhibits by Coulomb blockade the passage of signals on line L2 and diverts a signal from line L1 and line L2 to line L3.

Figure 13 shows another form of logic circuit which provides an AND and an EXOR (Exclusive OR) circuit. In response to inputs A, B, the circuit provides outputs in the manner shown in the drawing as will be evident to those skilled in the art in view of the foregoing description.

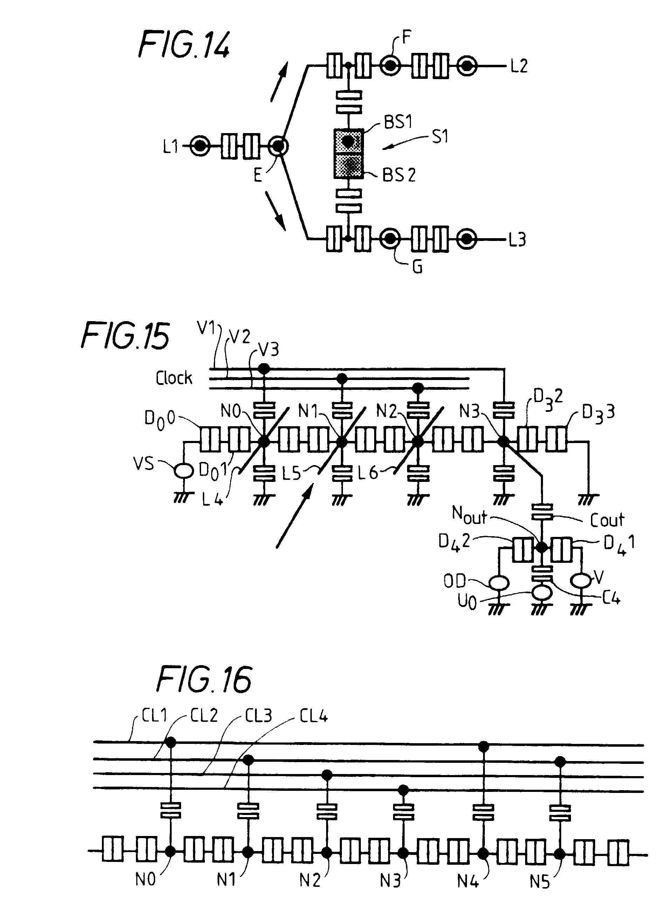

Figure 14 shows an example of a switch. An input on line L1 can be switched between lines L2 and L3 depending on the state of a switching element S1 connected between the lines L2, L3. The switch S1 conveniently comprises an assymetrical quantum dot configuration as described in UK Patent Application 9125727.9. The switching device can be considered as a bistable arrangement responsive to input optical radiation to switch its electron state between two bistable conditions. In Figure 14, the switch S1 is illustrated schematically to have first and second bistable electron states BS1, BS2 such that, for example, in response to input radiation, an electron can be considered to be held in state BS1 whereas in another condition, e.g. the absence of light, the electron can be switched into state BS2. When in state BS1, the electron produces a blocking effect for the passage of charge between node E and node F i.e. rendering the electron state of node F unstable so that electrons are preferentially clocked from node E to node G. Thus, data from line L1 is switched to line L3. The converse situation occurs when the switch S1 has its electron state switched to state BS2. Therefore, the circuit of Figure 14 operates as a switch so that data flowing on line L1 can be selectively switched to line L2 or L3 depending on the state of switch S1.

Referring now to Figure 15, this shows a sequence of logic units as described with reference to Figure 1 in more detail, with a voltage source and an output device, in order to explain in a more practical way how the device can be used to perform logical operations.

Single electrons from a voltage source VS pass through a pair of tunnel diodes D0 0, D0 1 to a first of the nodes N0 and then sequentially to nodes N1, N2, N3 as previously described with reference to Figure 1, under the control of clocking voltages V1, V2, V3. The node N3 is connected through a pair of tunnel diodes D3 2, D3 3 to earth so that the electron state of N3 is sequentially clocked to earth and the circuit operates in the manner of a shift register.

The electron states of the nodes N0 - N3 are controlled in a manner (for example as described with reference to Figure 9) so as to control the electron occupancy of the nodes. Thus, input logical control states are applied transversely on lines L4, 5, 6, to determine whether the stream of electrons sequentially clocked along the device are permitted to reside at the nodes during the clocking sequence. Thus, coupling through the lines L4 - L6 can change the stream of electron states that is sequentially clocked along the device. The resulting presence or absence of an electron (representing logical 1 and 0) is detected at the node N3 by an output device in the form of a Coulomb blockade electrometer. The electron occupancy of node N3 is detected through a capacitor $C_{out}$ connected to a node $N_{out}$ connected between a tunnel diode pair D4 1 - D4 2. The node $N_{out}$ is biassed by a voltage source U0 through a capacitor C4. The electrometer is voltage biassed with a source V near its Coulomb gap e/C' where C' is the combined capacitance of the tunnel diodes D4 2 and D4 1. The node is also charged biassed near e/4 by means of U0. Under these conditions, the electrometer current I varies linearly with small variations of the charge on the capacitance $C_{out}$ and the current is measured by an output device OD. For a further discussion of a Coulomb blockade electrometer, reference is directed to D.V. Averin and K.K. Likarov J. Low Temp. Physics 62, 345 (1986) and T.A. Fulton and G.J. Dolan, Physics Review Letters 59, 109 (1987).

Many modifications fall within the scope of the invention and many different logical combinations of the clocked nodes described herein will be apparent to those skilled in the art in view of the foregoing. In order to provide a practical circuit, it may be desirable to utilise a 4-clock system rather than the 3-clock waveforms described hereinbefore. An example of a 4-clock system is shown schematically in Figure 16. Also, it is possible to achieve the desired stable node states by the omission of capacitor C2 associated with each node N. This is also shown in Figure 16.

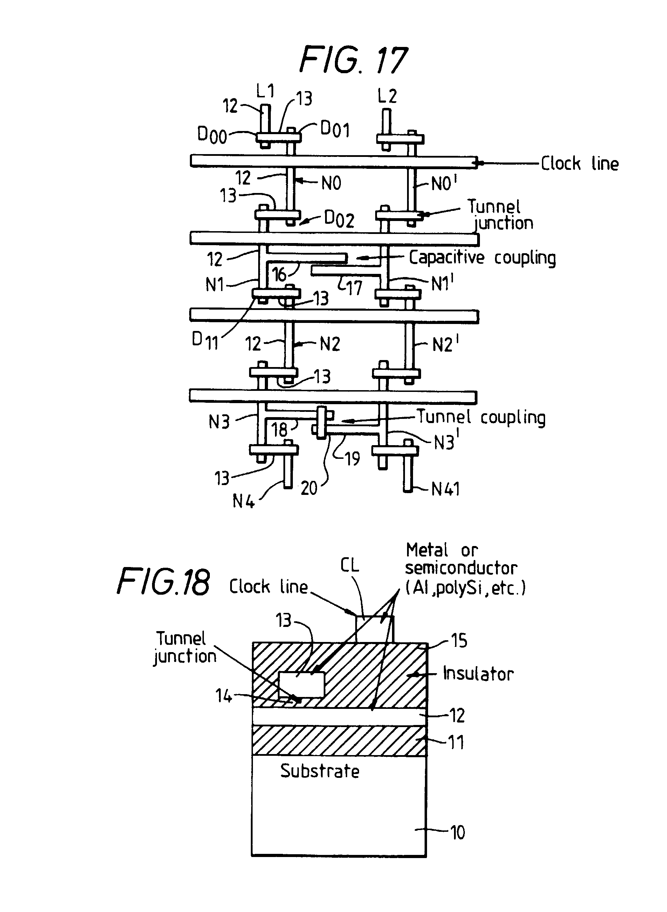

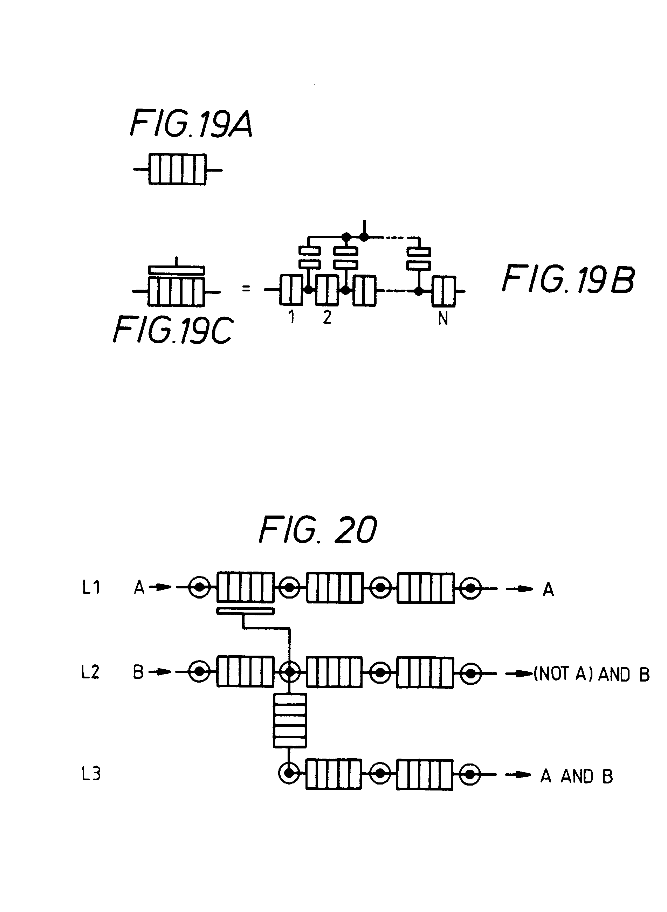

A practical form of device including the nodes, tunnel diodes and capacitors described hereinbefore will now be discussed in relation to Figures 17 and 18. The device consists of a substrate 10 with an overlaying insulating layer 11 in which are formed a plurality of conductive tracks that define the nodes tunnel diodes and capacitors shown for example in Figure 1.

Referring to Figure 17, the device consists of two parallel lines of nodes L1, L2 which are operated by four clock waveform lines CL1, 2, 3, 4. Considering the line L1, nodes N0 - N4 are formed by a plurality of parallel conductive channels 12, overlying the insulation layer 11 (shown in Figure 18). The tunnel junctions D are formed by an overlying conductor e.g. the conductor 13 shown in Figure 18, which is spaced from conductor 12 by a very thin layer of the insulator, referenced 14. Thus, the regions where the conductor 13 bridges the conductors 12 constitute tunnel diodes regions with a very small value of capacitance so as to provide the Coulomb blockade effects previously described. The various conductors 13 are covered by insulator 15 and the clock lines CL are formed on the surface thereof. The clock lines are capacitively coupled to the lines 12 through the insulator 15, which acts as a dielectric so as to define the capacitors C1 shown in Figure 1. The insulator 11 may act as a dielectric between the conductors 12 and the substrate 10 so as to form the capacitors C2, if required. The various layers shown in Figure 18 can be formed in a number of different ways. Typically, the substrate 10 is of silicon and the insulator comprises silicon dioxde. The conductive tracks 12, 13 and CL can be formed of a metal or a semiconductor such as polysilicon. The conductive channels 12, 13 can be formed by electron beam lithography.

Two logical interconnections between the lines L1 and L2 are shown in Figure 17. The nodes N1 of the lines L1 and N1' of L2 are interconnected by conductive tracks 16, 17 that are spaced apart by a region of the insulator 15 that forms a dielectric. Thus, the region of overlap between the tracks 16, 17 forms the capacitor such that the electron state of the node N1 of line L1 influences the electron state of the corresponding node in line L2.

Also, the nodes N3 and N3' of the adjacent lines L1 and L2 are interconnected by a pair of tunnel diodes. The nodes N3 and N3' are connected to respective conductive tracks 18, 19 that are bridged by a further conductor 20 corresponding in structure to conductor 13 of Figure 18. Thus, the conductors 18, 19, 20 form a pair of tunnel diodes so as to form a Coulomb blockade coupling between the nodes N3 and N3'.

Some further modificiations and variations will now be described. In the foregoing embodiments, the nodes N are interconnected by pairs of tunnel junctions connected in series. However, any number of tunnel junctions can be used for each series connection and an increase can reduce errors due to the so-called co-tunneling effect. Such a structure is known as a multiple-tunnel junction (MTJ) and is conventionally represented by the symbol shown in Figure 19a. A discussion of techniques for forming MTJs is given in Nakazato, K., Thornton, T.J., White J., and Ahmed, H.: "Single-electron effects in a point contact using a side-gating in delta-doped layers", Appl. Phys. Lett., 1992, 61, No. 26.

An alternative method for producing variable-resistance tunnel junctions is to use a split-gate method with modulation-doped structures as described in Kouwenhoven, L.P., Johnson, A.T., Van der Vaart, N.C., Van der Enden, A., Harmans, C.J.P.M. and Foxon, C.T.,: "Quantised current in a quantum dot turnstile", Z. Pys. B - Condensed Matter, 1991, 85, pp 381-388.

From Nakazato et al supra, it will be seen that side-gated structures can be produced with the circuit configuration as shown in Figure 19b and the symbol for such a circuit configuration is shown in Figure 19c.

Thus, the previously described circuits can be modified to use MTJs. Referring for example to Figure 20, this shows the circuit of Figure 12, modified to include MTJs. It will be appreciated that corresponding modifications can be made to the circuits shown in the other preceding Figures.

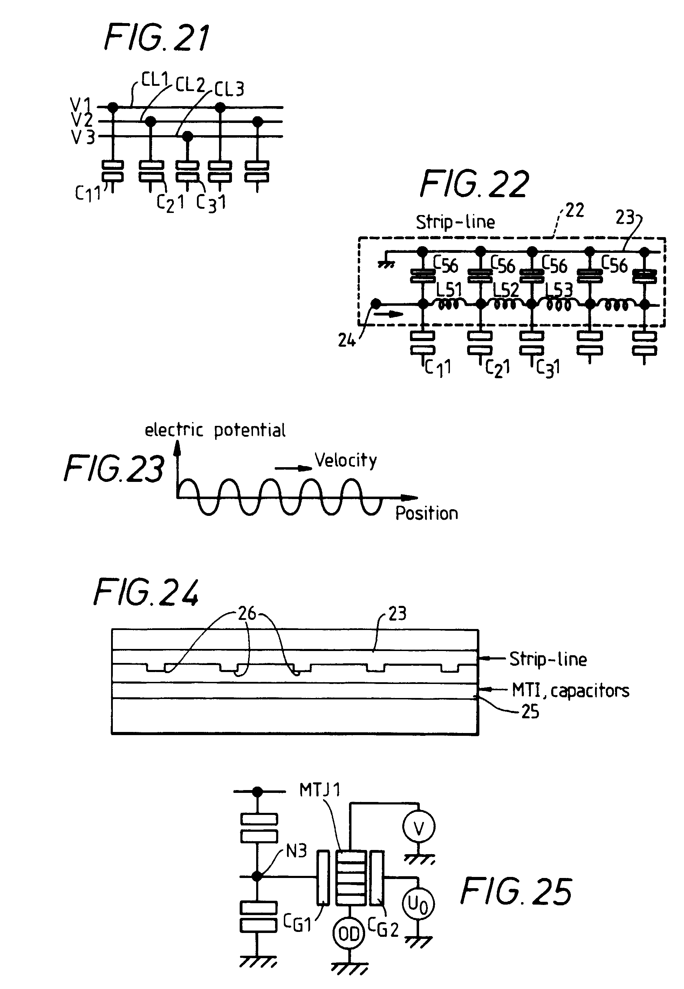

In another modification, the three or four phase clocking lines can be replaced by a strip line along which a time-dependent electric wave propagates. This can simplify the device structure. Thus, referring to Figure 21, this shows a detail of Figure 1 illustrating the three clock lines CL1 - 3 that apply the clocking waveforms V1 - 3 to capacitors C1 1, C2 1 and C3 1. Figure 22 shows an alternative arrangement in which a potential wave is transmitted along a strip-line to achieve the time-varying clocking potentials. Figure 23 shows the waveform transmitted along the strip-line and Figure 24 is an illustrative section of a substrate including such a strip-line.

Referring to Figure 22, the capacitors C1 1, C2 1 and C3 1 that in turn are connected to the sequence of Nodes N1 - N3, are connected to a strip-line shown within dotted outline 22. The strip-line consists of a lossy conductive strip that provides an inductive coupling Ls1, Ls3 between the capacitors C1 l, C2 l, C3 1 etc. The strip also exhibits a capacitance illustrated by capacitive elements Cs1 to an earth rail 23. Thus, in use, a time varying potential is applied to input terminal 24 so that a wave is transmitted along the strip line 22 as shown in Figure 23. As a result, waveforms corresponding to the clocking waveforms V1 - 3 are produced, but with a much simpler construction. Referring to Figure 24, the strip-line 22 can comprise a lossy conductive layer formed to overlie a layer of MTJs and capacitors 25, which defines the nodes N, the structure 25 being formed in accordance with the techniques disclosed by Nakazato et al **supra**. The layer 23 may include local regions 26 which define localised capacitive couplings with the layer 25.

Figure 25 shows a modification to the electrometer used to detect the output electron state, which can be used instead of the electrometer shown in Figure 15. In this arrangement, a multi-tunnel junction diode arrangement MTJ1 is provided with side gates Cg1 and Cg2 connected to the node N3 and to a voltage source U0 respectively. MTJ1 is also connected to a voltage source V and an output OD is taken, as shown in the Figure.

Whilst in the foregoing embodiments, the logic levels that the nodes N are defined by the presence or absence of a single electron, it will be appreciated that it is possible to use more than one electron to represent one bit of information, for example ten electrons. The control of electron flow is still however controlled by Coulomb blockade and such an arrangement may expand the operational range of the circuits but will require a modification of the device parameters such as capacitors and voltage.

## Claims

1. A logic device comprising:

   a charge storage node;
   barrier means;
   clock means for selectively altering the probability of charge carriers passing through the barrier means to the node during a clocking period, the device being so arranged that the amount of charge at the node is limited by Coulomb blockade whereby to define first and second logical levels; and
   output logic means for providing an output logic signal with different logical states in response to said logical levels of the node.

2. A device according to claim 1 including logic control means for applying a potential to the node to influence whether a charge carrier passes through the barrier to the node during the clocking period, whereby to influence the logical level of the node.

3. A device according to claim 1 or 2 including a first and a second of said charge storage nodes and a first and a second of said barrier means, the first barrier means being coupled to the first node, and the second barrier means being coupled between first and second nodes, said clocking means including means for cyclicly raising and lowering the probability of charge passing through the barrier means respectively whereby to permit charge to enter the first node through the first barrier means, and to permit charge from the first node to pass through the second barrier means to the second node.

4. A device according to claim 3 including at least one further barrier means and node connected to said second node in a line.

5. A device according to claim 4 including a plurality of said lines.

6. A device according to claim 5 including means for coupling the logical state of at least one node of one of the lines to the other of the lines.

7. A device according to any preceding claim including a logical unit comprising a plurality of said nodes, and means for coupling the logical state of said unit to another thereof.

8. A device according to claim 7 including a Coulomb electrometer for detecting the state of at least one of said nodes.

9. A device according to claim 7 including means for providing a plurality of clocking waveforms to respective nodes of each logic unit.

10. A device according to claim 9 including a transmission line for applying said clocking waveforms.

11. A device acording to any preceding claim wherein the or each barrier means comprises at least one tunnel junction.

12. A device according to any preceding claim wherein the or each said barrier means comprises first and second tunnel diodes connected in series.

13. A device according to any preceding claim wherein the or each barrier means comprises a multiple-tunnel junction.

14. A device according to any preceding claim wherein the or each said node comprises a conductive track formed on a substrate and the or each said barrier means comprises a tunnel diode including a conductive channel overlying said track and spaced therefrom by an electrically insulating region.

15. A device according to claim 14 including at least one clock line overlying said track.

## Patentansprüche

1. Logikvorrichtung mit

einem Ladungsspeicherknoten,

einer Barriereneinrichtung,

einer Takteinrichtung zum selektiven Ändern der Wahrscheinlichkeit, daß Ladungsträger die Barriereneinrichtung während eines Takt-Zeitintervalles nach dem Knoten durchlaufen, wobei die Vorrichtung so eingerichtet ist, daß die Ladungsmenge am Knoten durch Coulomb-Blockade begrenzt wird, wodurch erste und zweite Logikpegel definiert werden, und

einer Ausgangslogikeinrichtung zum Liefern eines Ausgangslogiksignals mit anderen Logikzuständen als Antwort auf die Logikpegel des Knotens.

2.  Vorrichtung nach Anspruch 1, mit einer Logiksteuereinrichtung zum Anlegen eines Potentials an den Knoten, um zu beeinflussen, ob ein Ladungsträger die Barriereneinrichtung während des Takt-Zeitintervalles nach dem Knoten durchläuft, um so den Logikpegels des Knotens zu beeinflussen.

3.  Vorrichtung nach Anspruch 1 oder 2, mit einem ersten und einem zweiten Ladungsspeicherknoten und mit einer ersten und einer zweiten Barriereneinrichtung, wobei die erste Barriereneinrichtung mit dem ersten Knoten verbunden ist und die zweite Barriereneinrichtung zwischen dem ersten und dem zweiten Knoten verbunden ist und wobei die Takteinrichtung eine Einrichtung zum zyklischen Erhöhen bzw. Erniedrigen der Wahrscheinlichkeit enthält, daß Ladungsträger die Barriereneinrichtung durchlaufen, um zu erlauben, daß Ladung durch die erste Barriereneinrichtung hindurch in den ersten Knoten eintritt, und um zu erlauben, daß Ladung aus dem ersten Knoten die zweite Barriereneinrichtung nach dem zweiten Knoten durchläuft.

4.  Vorrichtung nach Anspruch 3, mit wenigstens einer weiteren Barriereneinrichtung und einem weiteren Knoten, die in einer Reihe mit dem zweiten Knoten verbunden sind.

5.  Vorrichtung nach Anspruch 4, die eine Vielzahl der Reihen enthält.

6.  Vorrichtung nach Anspruch 5, mit einer Einrichtung zum Verbinden des Logikzustandes mindestens eines Knotens einer der Reihen mit einer anderen Reihe.

7.  Vorrichtung nach einem der vorhergehenden Ansprüche, mit einer Logikeinheit, die eine Vielzahl der Knoten aufweist, und mit einer Einrichtung zum Verbinden des Logikzustandes der Einheit mit einem anderen.

8.  Vorrichtung nach Anspruch 7, mit einem Coulomb-Elektrometer zum Nachweis des Zustandes mindestens eines der Knoten.

9.  Vorrichtung nach Anspruch 7, mit einer Einrichtung zum Liefern einer Vielzahl von Taktsignalformen an jeweilige Knoten jeder Logikeinheit.

10. Vorrichtung nach Anspruch 9, mit einer Übertragungsleitung zum Anlegen der Taktsignalformen.

11. Vorrichtung nach einem der vorhergehenden Ansprüche, bei der die oder jede Barriereneinrichtung wenigstens einen Tunnelübergang aufweist.

12. Vorrichtung nach einem der vorhergehenden Ansprüche, bei der die oder jede Barriereneinrichtung erste und zweite Tunneldioden aufweist, die in Serie verbunden sind.

13. Vorrichtung nach einem der vorhergehenden Ansprüche, bei der die oder jede Barriereneinrichtung einen Mehrfach-Tunnelübergang aufweist.

14. Vorrichtung nach einem der vorhergehenden Ansprüche, bei der der oder jeder Knoten eine leitfähige Spur aufweist, die auf einem Substrat gebildet ist, und bei der die oder jede Barriereneinrichtung eine Tunneldiode aufweist, die einen leitfähigen Kanal enthält, der über der Spur liegt und durch einen elektrisch isolierenden Bereich davon beabstandet ist.

15. Vorrichtung nach Anspruch 14, die mindestens eine Taktleitung enthält, die über der Spur liegt.

**Revendications**

1. Dispositif logique comprenant :

   un noeud d'accumulation de charge ;
   un moyen formant barrière ;
   un moyen de cadencement pour modifier de manière sélective la probabilité pour que des porteurs de charge passent à travers le moyen formant barrière vers le noeud pendant une période de cadencement, le dispositif étant agencé de façon que la valeur de charge au noeud soit limitée par blocus de Coulomb pour définir ainsi des premier et second niveaux logiques ; et
   un moyen logique de sortie destiné à délivrer un signal logique de sortie avec des états logiques différents en réponse auxdits niveaux logiques du noeud.

2. Dispositif selon la revendication 1, incluant un moyen de commande logique destiné à appliquer un potentiel au noeud pour influer sur le passage d'un porteur de charge à travers la barrière vers le noeud pendant la période de cadencement, de manière à influer ainsi sur le niveau logique du noeud.

3. Dispositif selon la revendication 1 ou 2, incluant un premier et un second noeuds d'accumulation de charge et un premier et un second moyens formant barrière, le premier moyen formant barrière étant raccordé au premier noeud, et le second moyen formant barrière étant raccordé entre des premier et second noeuds, ledit moyen de cadencement incluant un moyen destiné à, respectivement, élever et abaisser cycliquement la probabilité pour qu'une charge passe à travers le moyen formant barrière, en permettant ainsi à une charge d'entrer dans le premier noeud à travers le premier moyen formant barrière et en permettant à une charge provenant du premier noeud de passer à travers le second moyen formant barrière vers le second noeud.

4. Dispositif selon la revendication 3, incluant au moins un moyen formant barrière supplémentaire et un noeud connecté audit second noeud dans une ligne.

5. Dispositif selon la revendication 4, incluant une pluralité desdites lignes.

6. Dispositif selon la revendication 5, incluant un moyen destiné à raccorder l'état logique d'au moins un noeud de l'une des lignes à l'autre des lignes.

7. Dispositif selon l'une quelconque des revendications précédentes, incluant un module logique comprenant une pluralité desdits noeuds et un moyen destiné à raccorder l'état logique dudit module à un autre de ceux-ci.

8. Dispositif selon la revendication 7, incluant un électromètre de Coulomb destiné à détecter l'état d'au moins l'un desdits noeuds.

9. Dispositif selon la revendication 7, incluant un moyen destiné à fournir une pluralité de formes d'ondes de cadencement aux noeuds respectifs de chaque module logique.

10. Dispositif selon la revendication 9, incluant une ligne de transmission pour appliquer lesdites formes d'ondes de cadencement.

11. Dispositif selon l'une quelconque des revendications précédentes, dans lequel le, ou chaque, moyen formant barrière comprend au moins une jonction à effet tunnel.

12. Dispositif selon l'une quelconque des revendications précédentes, dans lequel le, ou chaque, moyen formant barrière comprend des première et seconde diodes à effet tunnel connectées en série

13. Dispositif selon l'une quelconque des revendications précédentes, dans lequel le, ou chaque, moyen formant barrière comprend une jonction à effet tunnel multiple.

14. Dispositif selon l'une quelconque des revendications précédentes, dans lequel le, ou chaque noeud, comprend une piste conductrice formée sur un substrat et le, ou chaque, moyen formant barrière comprend une diode à effet tunnel incluant un canal conducteur recouvrant ladite piste et qui en est espacé par une région isolante de l'électricité.

**15.** Dispositif selon la revendication 14, incluant au moins une ligne d'horloge recouvrant ladite piste.

## FIG.1

## FIG.2

## FIG.3A

## FIG.3B

## FIG.3C

FIG.4

FIG.5

$$\delta = \frac{C_1 + C_2}{2C_0}$$

FIG.6

$\bigcirc$ = Empty of electron.

## FIG. 7

## FIG.8

## FIG.9

## *FIG.10*

n = electron number on this node

$n = 0$

B  $A_1$

L2  C

$n = 1$

$A_2$

## *FIG. 11*

effective
potential

electron
flow

B

C

$A_1$

$A_2$

$n = 0$

effective
potential

electron flow

B  C

$A_2$  $A_1$

increase of effective potential
due to Coulomb repulsion

$n = 1$

## FIG.12

## FIG.13

AND and EXOR (Exclusive OR) circuit

EP 0 562 751 B1

FIG.14

FIG.15

FIG.16

# FIG. 17

# FIG. 18

## FIG.19A

## FIG.19B

## FIG.19C

## FIG. 20

L1  A →
L2  B →  (NOT A) AND B
L3  A AND B

## FIG. 21

## FIG. 22

## FIG. 23

electric potential

Velocity

Position

## FIG. 24

Strip-line

MTI, capacitors

## FIG. 25